# EUROPEAN PATENT SPECIFICATION

(11) **EP 4 567 552 B1**
(45) Date of publication and mention of the grant of the patent: **07.10.2026**
(21) Application number: 24209980.2
(22) Date of filing: 30.10.2024
(51) Int. Cl.: G06F 1/16, H04M 1/02, H04N 23/57

(54) **DISPLAY APPARATUS**
ANZEIGEGERÄT
APPAREIL D'AFFICHAGE

(30) Priority: 07.12.2023 KR 20230176849
(43) Date of publication of application: 11.06.2025
(73) Proprietor: LG Display Co., Ltd., Seoul 07336 (KR)
(72) Inventor: SON, Sungsik, 10845 Paju-si (KR)
(74) Representative: Morrall, Jonathan Ian McLachlan

(56) References cited:
- US-A1- 2020 192 148
- US-A1- 2021 149 157

## Description

### FIELD OF DISCLOSURE

The present disclosure relates to a display apparatus, and more specifically, to a display apparatus having a structure in which a camera module can be mounted stably.

### BACKGROUND

Contents described in this section simply provide background information on the present disclosure and do not constitute the related art.

In the full-fledged information age, the field of display apparatuses for visually displaying electrical information signals is developing rapidly, and research for developing performance, such as thinness, lightweight, and lower power consumption, for various display apparatuses is being continuously conducted.

Such display apparatuses include a liquid crystal display (LCD) device, a quantum dot display panel device (QD), a field emission display (FED) device, and an electro-wetting display (EWD) device, an organic light emitting diode (OLED) display apparatus, etc.

The display apparatuses have been developed to be miniaturized so that users may carry the display apparatuses or to be mounted on movable devices such as vehicles, etc., and are being improved so that the users may use the display apparatuses more conveniently.

US 2021/149157 A1 has an abstract that discloses an electronic device including a housing, and a camera module disposed in an inner space of the housing, wherein the camera module includes an image sensor and a plurality of lenses aligned with the image sensor, and wherein at least one of the plurality of lenses includes a first area formed to transfer at least a part of an external light to the image sensor and a second area including a light absorbing layer formed to absorb the at least a part of the external light and to penetrate from an outer surface of the lens into an inner space with a predetermined depth.

### SUMMARY

A display apparatus may be provided with a camera module to capture extemal images.

When the conventional display apparatus is provided with the camera module, a separate area is provided to arrange the camera module. That is, the camera module is disposed at a separate location spaced from the display module.

In the case of the conventional structure, an area of the display module becomes smaller and the overall area of the display apparatus becomes greater to provide a separate area for arranging the camera module.

Therefore, even when the display apparatus becomes greater, the size of a screen on which a user may actually view an image becomes smaller, thereby degrading the area efficiency and volume efficiency of the display apparatus.

To compensate the disadvantages of the related art, recent display apparatuses may be disposed at a location at which the display module is disposed without a separate area in which the camera module is disposed.

When the camera module is disposed on the display module, there is a need for a structure in which the location of the camera module mounted in the display apparatus can be maintained stably.

Therefore, the present disclosure is directed to providing a display apparatus having a structure in which a camera module may be mounted stably.

In addition, the present disclosure is directed to providing a display apparatus having a structure in which a camera module may be mounted simply.

In addition, the present disclosure is directed to providing a display apparatus having a mounting structure of a camera module, which may be processed inexpensively.

Objects of the present disclosure are not limited to the above-described objects, and other objects and advantages of the present disclosure which are not mentioned can be understood by the following description and more clearly understood by embodiments of the present disclosure. In addition, it will be able to be easily seen that the objects and advantages of the present disclosure may be achieved by devices and combinations thereof that are described in the claims.

A display apparatus according to the invention includes a display module configured to display a video, a metal plate disposed behind the display module, a printed circuit board disposed behind the metal plate and a camera module. The camera module includes a body and a lens barrel protruding from the body, in which a lens barrel is disposed at a location at which a first through hole formed in the display module is located. The metal plate includes a second through hole which is formed at a location corresponding to the first through hole and in which the lens barrel is located, and a rib formed at an edge of the second through hole in a circumferential direction of the second through hole and protruding toward the camera module, the body includes a seating groove which is formed in a shape corresponding to the rib and in which the rib is seated to maintain the mounted position of the camera module when the camera module is mounted in the display apparatus. The metal plate further includes a plurality of guide parts disposed to surround the second through hole and protruding toward the camera module, wherein the plurality of guide parts are configured to cooperate with the body of the camera module to position and guide the body of the camera module when the camera module is mounted in the display apparatus.

The metal plate may be provided with a plurality of guide parts which are spaced apart from each other to surround the body and determine an arrangement location of the body.

The metal plate may be provided with a formation hole for forming the guide part in the metal plate and the guide part is formed by bending a portion adjacent to the formation hole.

The rib may be formed by bending a portion in contact with the second through hole of the metal plate.

### BRIEF DESCRIPTION OF THE DRAWINGS

FIG. 1 is a front view showing a display apparatus according to one embodiment.
FIG. 2 is a rear view showing the display apparatus according to one embodiment.
FIG. 3 is a perspective view showing a front surface of a camera module according to one embodiment.
FIG. 4 is a perspective view showing a rear surface of the camera module according to one embodiment.
FIG. 5 is a partial view showing a state in which a preliminary through hole is formed in a metal plate according to one embodiment.
FIG. 6 is a partial view showing a state in which the processing is performed in FIG. 5 to form a second through hole.
FIG. 7 is a partial view showing a portion in which a third through hole is formed in a printed circuit board according to one embodiment.
FIG. 8 is a partial view showing a state in which the metal plate and the printed circuit board are coupled.
FIG. 9 is an enlarged view showing portion A in FIG. 2.
FIG. 10 is a cross-sectional view along line BB in FIG. 9.
FIG. 11 is a view showing a portion of the printed circuit board according to one embodiment.

### DETAILED DESCRIPTION

The above-described objects, features, and advantages will be described below in detail with reference to the accompanying drawings, and thus those skilled in the art to which the present disclosure pertains will be able to easily carry out the present disclosure. In describing the present disclosure, when it is determined that a detailed description of the known technology related to the present disclosure may unnecessarily obscure the gist of the present disclosure, a detailed description thereof will be omitted. Hereinafter, exemplary embodiments according to the present disclosure will be described in detail with reference to the accompanying drawings. In the drawings, the same reference numerals are used to denote the same or similar components.

Although terms such as first and second are used to describe various components, it goes without saying that the components are not limited by these terms. These terms are only used to distinguish one component from another component, and unless otherwise stated, it goes without saying that the first component may be the second component.

Throughout the specification, unless otherwise stated, each component may be singular or plural.

The singular expression used herein includes the plural expression unless the context clearly dictates otherwise. In the application, terms such as "composed of' or "comprising" should not be construed as necessarily including all of the various components or operations described in the specification and should be construed as not including some of the components or some of the operations or further including additional components or operations.

Throughout the specification, when "A and/or B" is described, this means A, B, or A and B unless otherwise specified, and when "C to D" is described, this means C or more and D or less unless otherwise specified.

In the following description, when the user views the display apparatus in a state in which the display apparatus is disposed to be generally used, a direction in which the user is located is referred to as "forward," and a direction opposite to the forward is referred to as "backward."

In addition, "vertically," "upper side," "lower side," "above," "under" indicates a location or direction of each component in a state in which the display apparatus is disposed to be generally used. In the drawing, "forward" indicates a +Z-axis direction, "backward" indicates a -Z-axis direction, and "vertically" indicates an X-axis direction.

The display apparatus according to the embodiment may be mounted, for example, in a cockpit of a vehicle to provide a video or image required for driving to a driver and a passenger of the vehicle. However, the present disclosure is not limited thereto, and the display apparatus may be used while carried by the user rather than mounted on the vehicle. Hereinafter, for example, a display apparatus mounted on a vehicle will be described.

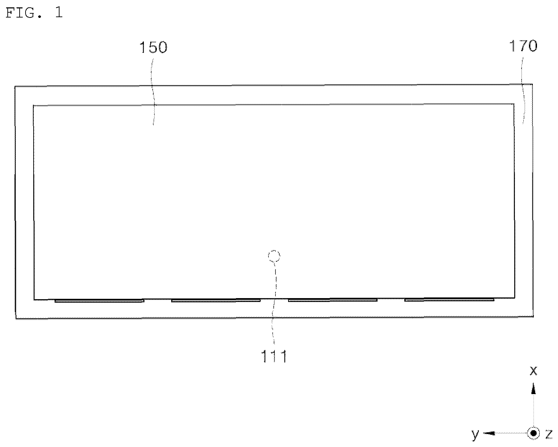

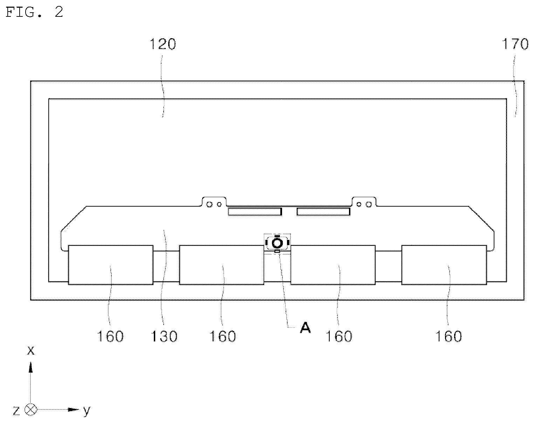

FIG. 1 is a front view showing a display apparatus according to one embodiment. FIG. 2 is a rear view showing the display apparatus according to one embodiment.

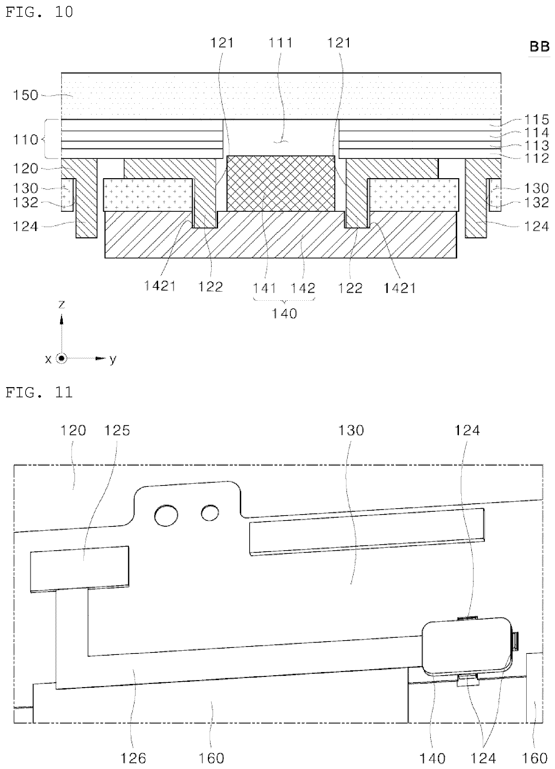

A display apparatus according to one embodiment may include a display module 110 (see FIG. 10), a metal plate 120, a cover member 150, a bezel 170, a printed circuit board 130, a chip-on-film (COF) 160, and a camera module 140.

The display module 110 may be provided to display a video or image. The video or image to be displayed may be navigation information necessary for traveling, video captured by a camera mounted on the vehicle, or various other contents needed by a driver or passengers.

A first through hole 111 through which a lens barrel 141 of the camera module 140 is disposed may be formed in an active area of the display panel 113 in the display module 110. Therefore, the lens barrel 141 may pass through the display module 110 to face the front of the display apparatus and capture a video. A specific structure of the display module 110 is described below.

The metal plate 120 may be disposed behind the display module 110. The metal plate 120 may serve as a heat sink for cooling the display panel 113 by dissipating heat generated from the display panel 113 provided in the display module 110 to the outside.

The metal plate 120 may be made of, for example, aluminum, copper, or a metal material containing the same, which has a high heat transfer rate. However, the present disclose is not limited thereto.

The cover member 150 may be disposed to cover the first through hole 111 in front of the display module 110. The cover member 150 may be disposed at the frontmost portion of the display apparatus. The cover member 150 may be disposed in front of the display panel 113 to protect the display panel 113. The cover member 150 may be made of a transparent material to allow light emitted from the display panel 113 to pass through the cover member 150.

Therefore, since the light passing through the cover member 150 made of a transparent material may be incident on the lens barrel 141, a forward image of the display apparatus may be captured.

The bezel 170 may be disposed to surround edges of the display module 110, the metal plate 120, and the cover member 150, couple the display module 110, the metal plate 120, and the cover member 150, and form a portion of the appearance of the display apparatus.

The printed circuit board 130 may be disposed behind the metal plate 120. The printed circuit board 130 may be disposed behind the metal plate 120 and electrically connected to the display panel 113.

The printed circuit board 130 may include the camera module 140, a device for communicating with extemal devices such as a main control module of a vehicle, a device for driving the display panel 113 so that the display panel 113 displays a video or image, etc., and provided with a circuit, and various other active and passive elements.

The COF 160 may have one side electrically connected to the display module 110 and the other side electrically connected to the printed circuit board 130. The COF 160 may be attached to one surface of the display panel 113 of the display module 110 and electrically connected to the display module 110.

The COF 160 may be disposed so that a portion is bent to surround an end portion of the metal plate 120. The COF 160 may be formed thinly and made of a flexible material to enable bending.

The COF 160 may electrically connect the display panel 113 with the printed circuit board 130. The COF 160 may be provided with various active and passive elements and provided with a driving circuit for driving the display panel 113.

The driving circuit for driving the display panel 113 may be provided to be dispersed to each of the printed circuit board 130 and the COF 160. The COF 160 may be provided with a driving element that forms at least a portion of the driving circuit of the display panel 113. A plurality of COFs 160 may be provided. The COFs 160 may be disposed to be spaced apart from each other.

The camera module 140 is mounted on the display apparatus to capture the forward image of the display apparatus. The camera module 140 may have the lens barrel 141 disposed at a location at which the first through hole 111 formed in the display module 110 is located.

When the conventional display apparatus is provided with the camera module 140, a separate area in which the camera module 140 is disposed is provided. That is, the camera module 140 is disposed at a separate location spaced apart from the display module 110.

In the case of the conventional structure, to provide a separate area in which the camera module 140 is disposed, the area of the display module 110 becomes smaller, and the overall area of the display apparatus becomes greater.

Therefore, even when the display apparatus becomes greater, the size of a screen on which a user may actually view an image becomes smaller, thereby degrading the area efficiency and volume efficiency of the display apparatus.

To compensate the disadvantages of the related art, recent camera module may be disposed at a location at which the display module 110 is disposed without a separate area in which the camera module 140 is disposed. The display apparatus according to the embodiment also has such a structure.

When the camera module 140 is disposed on the display module 110, there is a need for a structure in which the camera module 140 may be stably mounted on the display apparatus to maintain the location. This will be described in detail below.

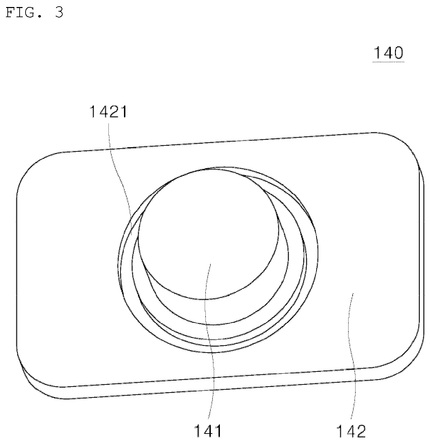

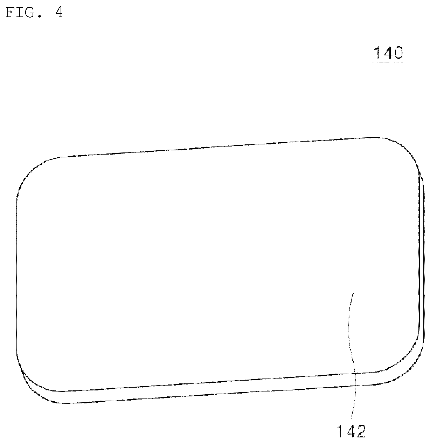

First, the camera module 140 according to one embodiment will be described. FIG. 3 is a perspective view showing a front surface of the camera module 140 according to one embodiment. FIG. 4 is a perspective view showing a back surface of the camera module 140 according to one embodiment.

To capture a high resolution image, the camera module 140 may include an auto focusing (AF) device, and an optical image stabilizing (OIS) device for correcting shaking of the camera module 140 due to an extemal impact.

The camera module 140 may include a body 142 and the lens barrel 141. The body 142 may be connected to the printed circuit board 130 to receive electricity from the printed circuit board 130 and may communicate with a controller provided on the printed circuit board 130. In addition, the body 142 may be implemented with various elements and circuits for controlling the AF and OIS operations of the lens barrel 141.

The lens barrel 141 may protrude from the body 142 and include at least one lens. For example, the lens barrel 141 may increase the resolutions of images captured by arranging various types of a plurality of lenses.

The body 142 may include a seating groove 1421. The seating groove 1421 may be formed in a shape corresponding to a rib 122 of the metal plate 120, and the rib 122 may be seated therein. As will be described below, the rib 122 may be formed to protrude from the metal plate 120 in a ring shape.

Therefore, the seating groove 1421 may be formed in a ring shape to correspond to the shape of the rib 122, formed by a recessed portion of the body 142, and formed to surround the lens barrel 141.

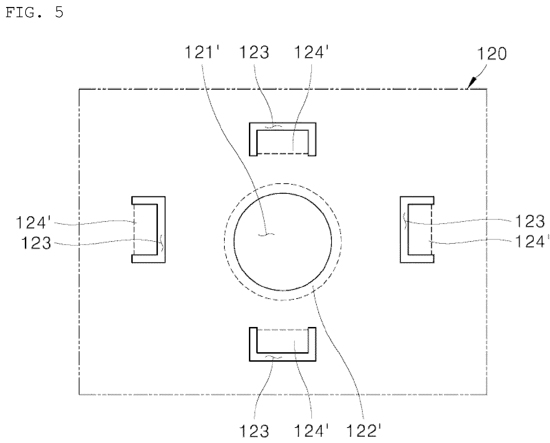

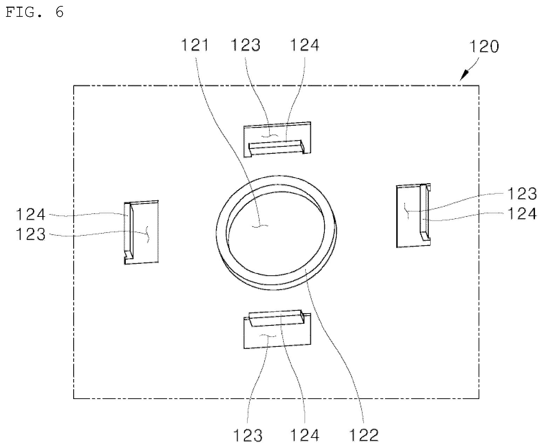

FIG. 5 is a partial view showing a state in which a preliminary through hole 121' is formed in the metal plate 120 according to one embodiment. FIG. 6 is a partial view showing a state in which the processing is performed in FIG. 5 to form a second through hole 121.

The metal plate 120 is a structure for mounting the camera module 140 and may include the second through hole 121 and a guide part 124. The second through hole 121 may be formed at a location corresponding to the first through hole 111, and the lens barrel 141 may be disposed therein. The second through hole 121 may be formed, for example, by punching the metal plate 120.

The lens barrel 141 may be disposed in the second through hole 121 to pass through the metal plate 120 to view the front of the display apparatus. The body 142 may be disposed behind the metal plate 120.

The guide part 124 may be disposed to surround the second through hole 121 and may protrude toward the camera module 140. A plurality of guide parts 124 may be provided and spaced apart from each other to surround the body 142 and determine the arrangement location of the body 142.

The plurality of guide parts 124 may be disposed at edges of the body 142 to support the body 142. Therefore, the plurality of guide parts 124 need to be disposed at locations that may stably support the body 142.

For example, the body 142 may be formed in a hexahedral shape, and each of the plurality of guide parts 124 may be disposed to support each side of the body 142. With this structure, the body 142 may be disposed inside the plurality of guide parts 124, and thus the plurality of guide parts 124 may determine the arrangement location of the body 142.

The body 142 mounted on the guide part 124 may be stably supported by the guide part 124 to maintain the mounted location. Meanwhile, the rib 122 of the metal plate 120, which will be described below, may determine the arrangement location of the body 142 together with the guide part 124.

The metal plate 120 is a structure for mounting the camera module 140 and may additionally include the rib 122. The rib 122 may be formed at an edge of the second through hole 121 in circumferential direction of the second through hole 121 in the metal plate 120 and may protrude toward the camera module 140.

Since the rib 122 is seated in the seating groove 1421 formed in the body 142 of the camera module 140, the camera module 140 may be mounted at a designed location of the metal plate 120 to maintain the mounted location.

Since the rib 122 is fitted into the seating groove 1421, the rib 122 and the seating groove 1421 may be manufactured in corresponding shapes. For example, the rib 122 and the seating groove 1421 may be provided in a ring shape surrounding the lens barrel 141. Meanwhile, a plurality of guide parts 124 may be provided to surround the rib 122.

The rib 122 may be formed by bending a portion of the metal plate 120, and since the rib 122 is provided in a ring shape, thereby making ending processing easier compared to other shapes and thus easily manufacturing the rib 122.

In an embodiment, the camera module 140 may be stably mounted on the metal plate 120 by the guide part 124 and the rib 122. Specifically, the lens barrel 141 may be disposed inside the rib 122.

In this case, the body 142 may be disposed to be surrounded by the plurality of guide parts 124, and an end portion of the rib 122 may be seated in the seating groove 1421. The camera module 140 may be stably mounted on the metal plate 120 by a dual structure of the guide part 124 and the rib 122 to maintain the mounted location.

In an embodiment, when the camera module 140 is mounted on the display apparatus, the mounted location is determined by the guide part 124 and the rib 122. Therefore, a worker simply fits the camera module 140 into the guide part 124 and the rib 122 without separately setting the arrangement location of the camera module 140. Therefore, the camera module 140 may be easily mounted on the display apparatus.

When the guide part 124 and the rib 122 are formed on the metal plate 120, a method such as casting, die casting, or injection may be used. However, the methods may require a separate mold frame.

In addition, the camera module 140 may be very small compared to the overall size of the display apparatus, and the guide part 124 and the rib 122 for mounting the camera module 140 may also be provided in very small sizes. Therefore, it is difficult to form the very small guide part 124 and rib 122 on the metal plate 120 using a method such as casting, and there is a high possibility of the occurrence of defects.

Hereinafter, an example in which the guide part 124 and the rib 122 are formed by using bending processing, which is simpler and has a lower defect rate than the method such as casting, will be described in detail.

The metal plate 120 may be provide with a formation hole 123 for forming the guide part 124 in the metal plate 120 and the guide part 124 is formed by bending a portion adjacent to the formation hole 123.

Since the metal plate 120 is made of a metal having excellent malleability and ductility, the guide part 124 and the rib 122 that have a relatively small volume may be formed through bending processing.

Referring to FIG. 5, the formation hole 123 for forming the guide part 124 may be formed at a designed location on the metal plate 120 through punching processing. For example, a plurality of formation holes 123 may be formed in a "U" shape at locations spaced apart from each other to surround the second through hole 121 or the preliminary through hole 121'.

In this case, a second area 124', which becomes the guide part 124 later, may be formed by the formation hole 123. In the bending processing, the second area 124' may be bent to protrude forward, and thus the second area 124' may become the guide part 124.

Such bending processing may be performed manually by the worker or using an automated bending machine.

The rib 122 may be formed by bending a portion of the metal plate 120 that is in contact with the second through hole 121. The second through hole 121 may be formed to have an expanded diameter as the rib 122 having a relatively small diameter is formed through bending.

Referring to FIG. 5, first, the preliminary through hole 121' having the relatively small diameter may be formed at a designed location of the metal plate 120 through the punching processing. A first area 122', which is provided in a ring shape and will become the rib 122 in the future, may be present at a location surrounding the preliminary through hole 121' of the metal plate 120.

Through the bending processing, the first area 122' may protrude forward, and thus the first area 122 may become the rib 122. For example, when a pressure is applied by inserting a rod-shaped tool having a diameter that is the same as or very similar to that of the second through hole into the preliminary through hole 121', the first area 122' may protrude to form the rib 122.

In this case, the preliminary through hole 121' having the relatively small diameter may have the expanded diameter as the rib 122 is formed through bending and thus become the second through hole having a relatively great diameter.

Since the metal plate 120 has excellent malleability and ductility, even when such bending processing is performed, the first area 122' of the metal plate 120 may be smoothly deformed without disconnection to become the rib 122.

The guide part 124 and the rib 122 may be easily formed through the punching processing and the bending processing according to the above-described method.

In an embodiment, the guide part 124 and the rib 122 may be formed on the metal plate 120 through the punching processing and the bending processing, and a separate mold frame for casting, die casting, injection, etc. cannot be used.

Therefore, the processing for forming the guide part 124 and the rib 122 can be easy, the manufacturing process of the display apparatus can be simplified, and manufacturing costs can be reduced. In addition, when the guide part 124 and the rib 122 that have relatively small volume throughout the display apparatus are formed, it is possible to significantly reduce the defect rate compared to the method such as casting.

The camera module 140 can increase the area efficiency and space efficiency of the display apparatus no matter in which part of the display module 110 is disposed. However, the camera module 140 may be disposed, for example, at a location overlapping the printed circuit board 130.

Specifically, a hole into which the lens barrel 141 is inserted may be formed in the printed circuit board 130, and the lens barrel 141 may be placed in the hole to be disposed at the location overlapping the printed circuit board 130.

When the camera module 140 is disposed on the printed circuit board 130, a cable 126 for electrically connecting the camera module 140 with the printed circuit board 130 may be easily installed, and compared to a case where the camera module 140 is not disposed on the printed circuit board 130, the cable 126 can be shortened, thereby increasing space efficiency in the display apparatus.

Hereinafter, the structure in which the camera module 140 is disposed on the printed circuit board 130, that is, the structure in which the camera module 140 and the printed circuit board 130 are disposed to overlap each other will be described in detail.

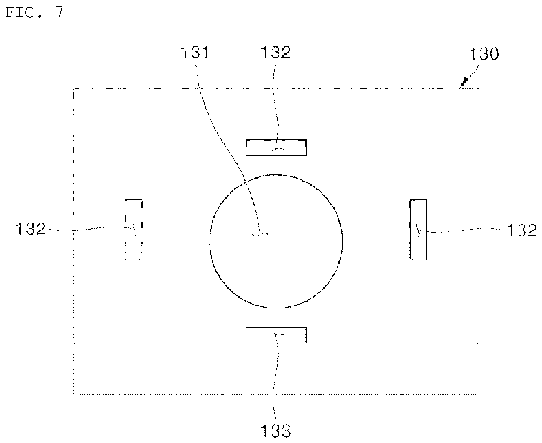

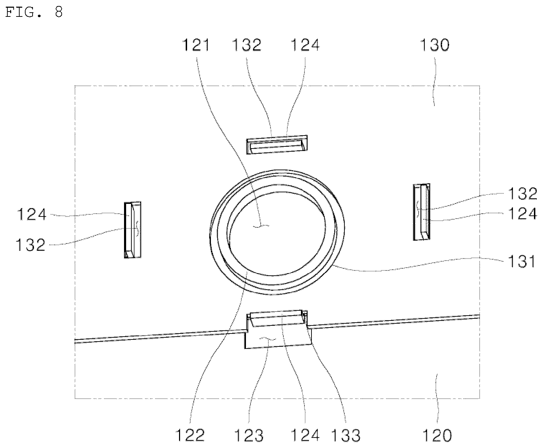

FIG. 7 is a partial view showing a portion in which a third through hole 131 is formed in the printed circuit board 130 according to one embodiment. FIG. 8 is a partial view showing a state in which the metal plate 120 and the printed circuit board 130 are coupled.

The printed circuit board 130 may include the third through hole 131 and an insertion hole 132 to arrange the camera module 140. The third through hole 131 may be formed at a location corresponding to the second through hole 121, and the lens barrel 141 may be disposed therein.

The lens barrel 141 may be disposed in the third through hole 131 to pass through the printed circuit board 130 and may also pass through the first through hole 111 and the second through hole 121 to face the display apparatus and capture the image.

The rib 122 may be inserted into the third through hole 131. The rib 122 may be disposed to protrude forward through the third through hole 131, and the rib 122 may be fitted into the seating groove 1421 of the body 142. With this structure, the camera module 140 and the metal plate 120 disposed with the printed circuit board 130 interposed therebetween may be coupled.

The insertion hole 132 may be formed at a location corresponding to the guide part 124, and the guide part 124 may be inserted therein. The number of insertion holes 132 may be equal to or smaller than the number of guide parts 124. That is, when a recessed groove 133 to be described below is formed in the printed circuit board 130 and the guide part 124 is inserted therein, the number of insertion holes 132 may be smaller than the number of guide parts 124.

For example, like a case where the rib 122 surrounds the second through hole 121, the insertion hole 132 may be disposed to surround at least a portion of the third through hole 131.

By inserting the guide part 124 into the insertion hole 132, the printed circuit board 130 may be stably disposed at the designed location on the metal plate 120. In addition, the guide part 124 passing through the insertion hole 132 may protrude forward, and the body 142 may be fitted into the guide part 124 and supported by the guide part 124. With this structure, the camera module 140 and the metal plate 120 disposed with the printed circuit board 130 interposed therebetween may be coupled.

The printed circuit board 130 may include the recessed groove 133 separately from the insertion hole 132 to arrange the camera module 140. The end portion of the printed circuit board 130 may be recessed to form the recessed groove 133, and the guide part 124 may be inserted into the recessed groove 133.

The guide part 124 needs to be disposed at the end portion of the printed circuit board 130 according to the arrangement location of the camera module 140 on the printed circuit board 130. In the case of this structure, the recessed groove 133 may be formed at the end portion of the printed circuit board 130, and some of the plurality of guide parts 124 may be inserted into the recessed groove 133 to protrude forward.

Like the guide part 124 passing through the insertion hole 132, the guide part 124 passing through the recessed groove 133 may protrude forward, and the body 142 may be fitted into the guide part 124 and supported by the guide part 124.

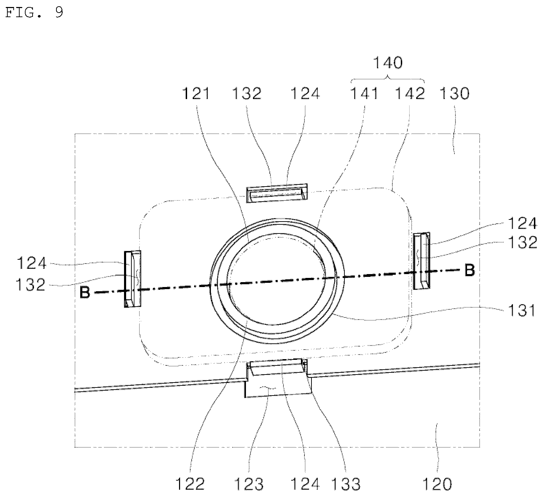

FIG. 9 is an enlarged view showing portion A in FIG. 2. FIG. 10 is a cross-sectional view along line BB in FIG. 9. As shown in FIG. 9, the lens barrel 141 may face the front of the display apparatus through the first through hole 111 and may be disposed in the second through hole 121 and the third through hole 131.

The cover member 150 closing the first through hole 111 may be made of a transparent material and may not block the view of the lens barrel 141.

An attachment unit may be provided to fixedly mount the camera module 140 to the display apparatus. For example, the body 142 of the camera module 140 may be in contact with the back surface of the printed circuit board 130, and thus may be attached to the printed circuit board 130 using a double-sided tape between the body 142 of the camera module 140 and the printed circuit board 130.

The display module 110 according to one embodiment may include a back plate 112, a display panel 113, a polarizer 114, and a fixing member 115.

The back plate 112 may be placed in front of the metal plate 120. The back plate 112 may be disposed between the display panel 113 and the metal plate 120. The back plate 112 may be attached to the rear surface of the display panel 113, thereby suppressing the display panel 113 from being damaged by being bent. That is, the back plate 112 may serve to reinforce the rigidity of the display panel 113.

The back plate 112 may be provided, for example, in the form of a film and attached to the display panel 113. However, the present disclosure is not limited thereto.

The display panel 113 may be disposed in front of the back plate 112 to display a video or image. The video or image to be displayed may be navigation information necessary for traveling, video captured by a camera mounted on the vehicle, or various other contents needed by a driver or passengers.

The display panel 113 may be electrically connected to the COF 160 and electrically connected to the printed circuit board 130 through the COF 160. Therefore, the controller and driving elements provided on the COF 160 and/or the printed circuit board 130 may control the operation of the display panel 113.

The polarizer 114 may be disposed in front of the display panel 113. The polarizer 114 may be disposed between the display panel 113 and the fixing member 115. The polarizer 114 can increase outdoor visibility and contrast ratio for images displayed on the display panel 113 by preventing reflection of extemal light.

The fixing member 115 may be disposed in front of the polarizer 114. The fixing member 115 may be disposed between the cover member 150 and the display panel 113 to attach the display panel 113 to the cover member 150. The fixing member 115 may be made of a transparent material because light emitted from the display panel 113 should pass through the fixing member 115.

Therefore, the fixing member 115 may be made of or include a material that is transparent and has good adhesion, such as an optical clear adhesive (OCA), an optical clear resin (OCR), or a pressure sensitive adhesive (PSA).

The first through hole 111 may be formed by removing the display panel 113, the polarizer 114, and the fixing member 115. A light blocking layer for preventing light leakage may be disposed on side surface portions of the display panel 113, the polarizer 114, and the fixing member 115 that are disposed in the first through hole 111.

Meanwhile, a cushion plate for cushioning may be disposed between the back plate 112 and the metal plate 120. The cushion plate may mitigate the impact applied to various parts of the display apparatus and include an embossing layer and a cushion layer.

The embossing layer may be disposed behind the back plate 112. The embossing layer may be disposed to be bonded to the back plate 112 and formed as an adhesive layer having an embossing pattern. The embossing pattern of the embossing layer may be, for example, an uneven structure formed on the surface.

Since the embossing layer may be in direct contact with the back plate 112 to fix the cushion layer to the back plate 112, the embossing layer may serve as an adhesive layer by containing an adhesive component. The embossing layer may be made of or include materials such as the OCA, the OCR, or the PSA.

The embossing layer may have the thickness of at least 40 *µ*m or more for an adhesion function and bubble prevention.

The cushion layer may be disposed between the embossing layer and the metal plate 120. The cushion layer may be formed of a foam tape or a foam pad. The cushion layer may serve to mitigate the impact of various parts that may be in contact with the cushion plate. In addition, the cushion layer can reinforce the rigidity of the cushion plate.

The cushion plate may include a porous member in another embodiment. The porous member may be attached to the embossing layer or cushion layer to become an element forming the cushion plate. The porous member may be a metal foam.

The porous member together with the cushion layer may serve as a kind of a cushion means, thereby mitigating the impact of various parts that may be in contact with the cushion plate. In addition, the porous member may be made of a metal material to reinforce the rigidity of the cushion plate.

The lens barrel 141 may be disposed in the first through hole 111 formed in the display module 110 and disposed under the display panel 113 to form a separation space between the lens barrel 141 and the cover member 150.

FIG. 11 is a view showing a portion of the printed circuit board 130 according to one embodiment. The camera module 140 may be electrically connected to the printed circuit board 130, the operation thereof may be controlled by the controller provided on the printed circuit board 130, and the camera module 140 may receive electricity from the printed circuit board 130.

For electrical connection between the camera module 140 and the printed circuit board 130, the printed circuit board 130 may be provided with a connector 125. In addition, the display apparatus may include the cable 126 having one end coupled to the connector 125 and the other end coupled to the camera module 140 to electrically connect the camera module 140 with the printed circuit board 130.

In an embodiment, the camera module 140 may be disposed at a location overlapping the printed circuit board 130 in a front-rear direction of the display apparatus. In addition, the connector 125 may be provided on the printed circuit board 130.

With this structure, the cable 126 connecting the camera module 140 with the printed circuit board 130 may be disposed to overlap the printed circuit board 130 in the front-rear direction of the display apparatus.

Therefore, the cable 126 may be provided relatively short, and an extra space for arranging the cable 126 can be minimized. In addition, there is no need to provide a separate space for arranging the cable 126 on the xy plane perpendicular to the front-rear direction.

By arranging the camera module 140 to overlap the printed circuit board 130, it is possible to minimize the extra space for arranging the cable 126, thereby increasing the area efficiency and space efficiency of the display apparatus.

A display apparatus may include a display module for displaying a video, a meta plate disposed behind the display module, a printed circuit board disposed behind a metal plate, and a camera module in which a lens barrel is disposed at a location at which a first through hole formed in the display module is located, in which the metal plate may include a second through hole which is formed at a location corresponding to the first through hole and in which the lens barrel is disposed, and a guide part disposed to surround the second through hole and protruding toward the camera module.

The camera module may include a body, and the lens barrel protruding from the body and including at least one lens, in which a plurality of guide parts may be provided in the metal plate and spaced apart from each other to surround the body and determine an arrangement location of the body.

The body may be formed in a hexahedral shape, and each of the plurality of guide parts may be disposed to support each side of the body.

The guide part may be provided with a formation hole for forming the guide part in the metal plate and formed by bending a portion adjacent to the formation hole.

The printed circuit board may include a third through hole which is formed at a location corresponding to the second through hole and in which the lens barrel is disposed, and an insertion hole which is formed at a location corresponding to the guide part and into which the guide part is inserted.

The metal plate may include a rib formed at an edge of the second through hole in a circumferential direction of the second through hole and protruding toward the camera module.

The rib may be formed by bending a portion of the metal plate in contact with the second through hole.

The second through hole may be formed to have an expanded diameter as the rib having a relatively small diameter is formed through bending.

The body may include a seating groove which is formed in a shape corresponding to the rib and in which the rib is seated.

The rib and the seating groove may be provided in a ring shape surrounding the lens barrel.

The lens barrel may be disposed inside the rib, the body may be disposed to be surrounded by a plurality of the guide parts, and an end portion of the rib may be seated in the seating groove.

The printed circuit board may include a recessed groove which is formed by a recessed end portion and into which the guide part is inserted.

The plurality of guide parts may be provided to surround the rib.

The display module may include a back plate disposed in front of the metal plate, a display panel disposed in front of the back plate and displaying an image, a polarizer disposed in front of the display panel, and a fixing member disposed in front of the polarizer.

The display apparatus may include a cover member disposed to cover the first through hole in front of the display module.

A display apparatus according to another example may include a display module for displaying a video, a metal plate disposed behind the display module, a printed circuit board disposed behind the metal plate, a camera module in which a lens barrel is disposed at a location at which a first through hole disposed in the display module is located, a cover member disposed to cover the first through hole in front of the display module, and a chip on film (COF) having one side electrically connected to the display module and the other side electrically connected to the printed circuit board, in which the metal plate may include a second through hole which is formed at a location corresponding to the first through hole and in which the lens barrel is disposed, a guide part disposed to surround the second through hole and protruding toward the camera module, and a rib formed in a circumferential direction of the second through hole at an edge of the second through hole and protruding toward the camera module.

The metal plate may be provided with a formation hole for forming the guide part in the metal plate and the guide part is formed by bending a portion adjacent to the formation hole, and the rib may be formed by bending a portion of the metal plate in contact with the second through hole.

The printed circuit board may include a third through hole which is formed at a location corresponding to the second through hole and in which the lens barrel is disposed, an insertion hole which is formed at a location corresponding to the guide part and into which the guide part is inserted, and a recessed groove which is formed by a recessed end portion and into which the guide part is inserted.

The camera module may include a body, and the lens barrel protruding from the body and including at least one lens, in which the body may include a seating groove which is formed in a shape corresponding to the rib and in which the rib is seated.

In the display apparatus according to the present disclosure, the camera module can be stably mounted on the metal plate by the guide part and the rib. Specifically, the lens barrel may be disposed inside the rib.

In this case, the body may be disposed to be surrounded by a plurality of guide parts, and an end portion of the rib may be seated in a seating groove. The camera module can be stably mounted on the metal plate to maintain the mounted location by the dual structure of the guide part and the rib.

In addition, in the display apparatus according to the present disclosure, when the camera module is mounted on the display apparatus, the mounting located is determined by the guide part and the rib, and thus the worker simply fits the camera module into the guide part and the rib without separately setting the arrangement location of the camera module. Therefore, the camera module can be easily mounted on the display apparatus.

In addition, in the display apparatus according to the present disclosure, the guide part and the rib are formed on the metal plate through punching processing and bending processing, and a separate mold for casting, die casting, injection, etc. cannot be used.

Therefore, the processing to form the guide part and the rib can be easy, the manufacturing process of the display apparatus can be simplified, and the manufacturing costs thereof can be reduced. In addition, when the guide part and rib having the relatively small in volume in the entirety of the display apparatus are formed, it is possible to significantly reduce the defect rate compared to the method such as casting.

Specific effects together with the above-described effects are described together with a description of the following detailed matters for carrying out the invention.

Although the present disclosure has been described above with reference to exemplary drawings, the present disclosure is not limited by the embodiments and drawings disclosed in the specification, and it is apparent that various modifications can be made by those skilled in the art within the scope of the present disclosure. In addition, even when the operational effects according to the configuration of the present disclosure have not been explicitly described in the description of the embodiments of the present disclosure, it goes without saying that the effects predictable by the corresponding configuration should be recognized. The scope of the invention is defined by the appended claims.

## Claims

1. A display apparatus comprising:
a display module (110) configured to display a video;
a metal plate (120) disposed behind the display module;
a printed circuit board (130) disposed behind the metal plate; and
a camera module (140) including a body (142) and a lens barrel (141) protruding from the body, in which the lens barrel is disposed at a location at which a first through hole (111) formed in the display module is located,
wherein the metal plate includes:
a second through hole (121) which is formed at a location corresponding to the first through hole and in which the lens barrel is located, and a rib (122) formed at an edge of the second through hole in a circumferential direction of the second through hole and protruding toward the camera module, the body includes a seating groove (1421) which is formed in a shape corresponding to the rib and in which the rib is seated to maintain the mounted position of the camera module when the camera module is mounted in the display apparatus; and
a plurality of guide parts (124) disposed to surround the second through hole and protruding toward the camera module, wherein the plurality of guide parts are configured to cooperate with the body of the camera module to position and guide the body of the camera module when the camera module is mounted in the display apparatus.

2. The display apparatus of claim 1, wherein the lens barrel includes at least one lens,
the plurality of guide parts are spaced apart from each other to surround the body and determine an arrangement location of the body.

3. The display apparatus of claim 2, wherein the body is formed in a hexahedral shape, and each of the plurality of guide parts is disposed to support each side of the body of the camera module.

4. The display apparatus of claim 2 or claim 3, wherein the metal plate is provided with a plurality of formation holes (123) for forming the plurality of guide parts in the metal plate and the plurality of guide parts are each formed by bending a portion adjacent to the formation hole.

5. The display apparatus of any one of claims 2 to 4, wherein the printed circuit board includes:
a third through hole (131) which is formed at a location corresponding to the second through hole and in which the lens barrel is located; and
insertion holes which are formed at locations corresponding to the plurality of guide parts and into which the guide parts are inserted.

6. The display apparatus of any preceding claim, wherein the rib is formed by bending a portion in contact with the second through hole of the metal plate.

7. The display apparatus of any preceding claim, wherein the second through hole is formed to have an expanded diameter as the rib having a relatively small diameter is formed through bending,

8. The display apparatus of any preceding claim, wherein the rib and the seating groove are provided in a ring shape surrounding the lens barrel.

9. The display apparatus of any preceding claim, wherein the lens barrel is disposed inside the rib,
the body is disposed to be surrounded by a plurality of guide parts, and
an end portion of the rib is seated in the seating groove.

10. The display apparatus of any one of claims 2 to 9, wherein the printed circuit board includes a recessed groove (133) which is formed by a recessed end portion and into which some of the plurality of guide parts is inserted.

11. The display apparatus of any preceding claim, wherein the plurality of guide parts are provided to surround the rib.

12. The display apparatus of any preceding claim, wherein the display module includes:
a back plate (112) disposed in front of the metal plate;
a display panel (113) disposed in front of the back plate and configured to display the video;
a polarizer (114) disposed in front of the display panel; and
a fixing member (115) disposed in front of the polarizer.

13. The display apparatus of any preceding claim, further comprising a cover member (150) disposed to cover the first through hole in front of the display module.

14. The display apparatus of any preceding daim, further comprising a chip on film, COF, (160) having one side electrically connected to the display module and the other side electrically connected to the printed circuit board.

## Patentansprüche

1. Anzeigeeinrichtung, umfassend:
ein Anzeigemodul (110), das dazu ausgelegt ist, ein Video anzuzeigen;
eine Metallplatte (120), die hinter dem Anzeigemodul angeordnet ist;
eine Leiterplatte (130), die hinter der Metallplatte angeordnet ist; und
ein Kameramodul (140), das einen Körper (142) und einen von dem Körper vorstehenden Objektivtubus (141) umfasst, wobei der Objektivtubus an einer Stelle angeordnet ist, an der eine erste in dem Anzeigemodul ausgebildete Durchgangsöffnung (111) angeordnet ist,
wobei die Metallplatte Folgendes umfasst:
eine zweite Durchgangsöffnung (121), die an einer Stelle ausgebildet ist, die der ersten Durchgangsöffnung entspricht, und in der der Objektivtubus angeordnet ist, und eine Rippe (122), die an einer Kante der zweiten Durchgangsöffnung in einer Umfangsrichtung der zweiten Durchgangsöffnung ausgebildet ist und in Richtung des Kameramoduls vorsteht, wobei der Körper eine Aufnahmenut (1421) umfasst, die in einer Form ausgebildet ist, die der Rippe entspricht, und in der die Rippe aufgenommen ist, um die Montageposition des Kameramoduls beizubehalten, wenn das Kameramodul in der Anzeigeeinrichtung montiert ist; und
mehrere Führungsteile (124), die so angeordnet sind, dass sie die zweite Durchgangsöffnung umgeben, und in Richtung des Kameramoduls vorstehen, wobei die mehreren Führungsteile dazu ausgelegt sind, mit dem Körper des Kameramoduls zusammenzuwirken, um den Körper des Kameramoduls zu positionieren und zu führen, wenn das Kameramodul in der Anzeigeeinrichtung montiert ist.

2. Anzeigeeinrichtung nach Anspruch 1, wobei der Objektivtubus mindestens ein Objektiv umfasst,
wobei die mehreren Führungsteile so voneinander beabstandet sind, dass sie den Körper umgeben, und eine Anordnungsstelle des Körpers bestimmen.

3. Anzeigeeinrichtung nach Anspruch 2, wobei der Körper in einer Hexaederform ausgebildet ist und jedes der mehreren Führungsteile so angeordnet ist, dass jede Seite des Körpers des Kameramoduls gestützt ist.

4. Anzeigeeinrichtung nach Anspruch 2 oder Anspruch 3, wobei die Metallplatte mit mehreren Ausbildungsöffnungen (123) zum Ausbilden der mehreren Führungsteile in der Metallplatte versehen ist und die mehreren Führungsteile jeweils durch Biegen eines Abschnitts angrenzend an die Ausbildungsöffnung ausgebildet sind.

5. Anzeigeeinrichtung nach einem der Ansprüche 2 bis 4, wobei die Leiterplatte Folgendes umfasst:
eine dritte Durchgangsöffnung (131), die an einer Stelle ausgebildet ist, die der zweiten Durchgangsöffnung entspricht, und in der der Objektivtubus angeordnet ist; und
Einsetzöffnungen, die an Stellen ausgebildet sind, die den mehreren Führungsteilen entsprechen, und in die die Führungsteile eingesetzt sind.

6. Anzeigeeinrichtung nach einem der vorhergehenden Ansprüche, wobei die Rippe durch Biegen eines Abschnitts in Kontakt mit der zweiten Durchgangsöffnung der Metallplatte ausgebildet ist.

7. Anzeigeeinrichtung nach einem der vorhergehenden Ansprüche, wobei die zweite Durchgangsöffnung so ausgebildet ist, dass sie einen vergrößerten Durchmesser aufweist, während die Rippe mit einem relativ kleinen Durchmesser durch Biegen ausgebildet ist,

8. Anzeigeeinrichtung nach einem der vorhergehenden Ansprüche, wobei die Rippe und die Aufnahmenut in einer Ringform bereitgestellt sind, die den Objektivtubus umgibt.

9. Anzeigeeinrichtung nach einem der vorhergehenden Ansprüche, wobei der Objektivtubus innerhalb der Rippe angeordnet ist,
wobei der Körper so angeordnet ist, dass er von mehreren Führungsteilen umgeben ist, und
wobei ein Endabschnitt der Rippe in der Aufnahmenut aufgenommen ist.

10. Anzeigeeinrichtung nach einem der Ansprüche 2 bis 9, wobei die Leiterplatte eine vertiefte Nut (133) umfasst, die durch einen vertieften Endabschnitt ausgebildet ist und in die einige der mehreren Führungsteile eingesetzt sind.

11. Anzeigeeinrichtung nach einem der vorhergehenden Ansprüche, wobei die mehreren Führungsteile so bereitgestellt sind, dass sie die Rippe umgeben.

12. Anzeigeeinrichtung nach einem der vorhergehenden Ansprüche, wobei das Anzeigemodul Folgendes umfasst:
eine Rückplatte (112), die vor der Metallplatte angeordnet ist;
ein Anzeigefeld (113), das vor der Rückplatte angeordnet und dazu ausgelegt ist, das Video anzuzeigen;
einen Polarisator (114), der vor dem Anzeigefeld angeordnet ist; und
ein Befestigungselement (115), das vor dem Polarisator angeordnet ist.

13. Anzeigeeinrichtung nach einem der vorhergehenden Ansprüche, die ferner ein Abdeckelement (150) umfasst, das so angeordnet ist, dass es die erste Durchgangsöffnung vor dem Anzeigemodul abdeckt.

14. Anzeigeeinrichtung nach einem der vorhergehenden Ansprüche, die ferner einen Chip-on-Film, COF, (160) umfasst, dessen eine Seite elektrisch mit dem Anzeigemodul verbunden ist und dessen andere Seite elektrisch mit der Leiterplatte verbunden ist.

## Revendications

1. Appareil d'affichage comprenant :
un module d'affichage (110) configuré pour afficher une vidéo ;
une plaque métallique (120) disposée derrière le module d'affichage ;
une carte de circuit imprimé (130) disposée derrière la plaque métallique ; et
un module de caméra (140) comprenant un corps (142) et un barillet de lentille (141) faisant saillie à partir du corps, dans lequel le barillet de lentille est disposé à un emplacement auquel se trouve un premier trou traversant (111) formé dans le module d'affichage,
la plaque métallique comportant :
un deuxième trou traversant (121) qui est formé à un emplacement correspondant au premier trou traversant et dans lequel est situé le barillet de lentille, et une nervure (122) formée au niveau d'un bord du deuxième trou traversant dans une direction circonférentielle du deuxième trou traversant et faisant saillie vers le module de caméra, le corps comprenant une rainure d'assise (1421) qui est formée dans une forme correspondant à la nervure et dans laquelle la nervure est assise pour maintenir la position de montage du module de caméra lorsque le module de caméra est monté dans l'appareil d'affichage ; et
une pluralité de parties de guidage (124) disposées de manière à entourer le deuxième trou traversant et faisant saillie vers le module de caméra, la pluralité de parties de guidage étant configurées pour coopérer avec le corps du module de caméra afin de positionner et de guider le corps du module de caméra lorsque le module de caméra est monté dans l'appareil d'affichage.

2. Appareil d'affichage selon la revendication 1, le barillet de lentille comprenant au moins une lentille, la pluralité de parties de guidage étant espacées les unes des autres pour entourer le corps et déterminer un emplacement d'agencement du corps.

3. Appareil d'affichage selon la revendication 2, le corps étant formé en une forme hexaédrique, et chacune de la pluralité de parties de guidage étant disposée pour supporter chaque côté du corps du module de caméra.

4. Appareil d'affichage selon la revendication 2 ou la revendication 3, la plaque métallique étant pourvue d'une pluralité de trous de formation (123) pour former la pluralité de parties de guidage dans la plaque métallique et la pluralité de parties de guidage étant formées chacune en courbant une partie adjacente au trou de formation.

5. Appareil d'affichage selon l'une quelconque des revendications 2 à 4, la carte de circuit imprimé comprenant :
un troisième trou traversant (131) qui est formé à un emplacement correspondant au deuxième trou traversant et dans lequel est situé le barillet de lentille ; et
des trous d'insertion qui sont formés à des emplacements correspondant à la pluralité de pièces de guidage et dans lesquels les pièces de guidage sont insérées.

6. Appareil d'affichage selon l'une quelconque des revendications précédentes, la nervure étant formée en courbant une partie en contact avec le deuxième trou traversant de la plaque métallique.

7. Appareil d'affichage selon l'une quelconque des revendications précédentes, le deuxième trou traversant étant formé pour avoir un diamètre dilaté lorsque la nervure ayant un diamètre relativement petit est formée par flexion,

8. appareil d'affichage selon l'une quelconque des revendications précédentes, la nervure et la rainure d'assise étant prévues en une forme annulaire entourant le barillet de lentille.

9. Appareil d'affichage selon l'une quelconque des revendications précédentes, le barillet de lentille étant disposé à l'intérieur de la nervure,
le corps étant disposé de manière à être entouré par une pluralité de parties de guidage, et
une partie d'extrémité de la nervure étant assise dans la rainure d'assise.

10. Appareil d'affichage selon l'une quelconque des revendications 2 à 9, la carte de circuit imprimé comprenant une rainure évidée (133) qui est formée par une partie d'extrémité évidée et dans laquelle une partie de la pluralité de parties de guidage est insérée.

11. Appareil d'affichage selon l'une quelconque des revendications précédentes, la pluralité de parties de guidage étant prévues pour entourer la nervure.

12. Appareil d'affichage selon l'une quelconque des revendications précédentes, le module d'affichage comprenant :
une plaque arrière (112) disposée devant la plaque métallique ;
un panneau d'affichage (113) disposé devant la plaque arrière et configuré pour afficher la vidéo ;
un polariseur (114) disposé devant le panneau d'affichage ; et
un élément de fixation (115) disposé devant le polariseur.

13. Appareil d'affichage selon l'une quelconque des revendications précédentes, comprenant en outre un élément de couvercle (150) disposé pour couvrir le premier trou traversant devant le module d'affichage.

14. Appareil d'affichage selon l'une quelconque des revendications précédentes, comprenant en outre une puce sur film, COF, (160) ayant un côté électriquement connecté au module d'affichage et l'autre côté électriquement connecté à la carte de circuit imprimé.
